# EUROPEAN PATENT APPLICATION

(11) **EP 4 435 976 A1**
(43) Date of publication of application: **25.09.2024**
(21) Application number: 23163896.6
(22) Date of filing: 24.03.2023
(51) Int. Cl.: H01R 12/91, H01R 13/631, H01R 13/6599, H01R 13/6594, H01R 12/71, H01R 12/70, H01R 13/24

(54) **ELECTRICAL CONNECTOR**

(71) Applicant: ASML Netherlands B.V., 5500 AH Veldhoven (NL)
(72) Inventor: BEX, Jan, 5500 AH Veldhoven (NL); RUIJL, Theo, Anjes, Maria, 5500 AH Veldhoven (NL); RAAYMAKERS, Jeroen, Arnoldus, Leonardus, Johannes, 5500 AH Veldhoven (NL); DAMEN, Johannes, Wilhelmus, 5500 AH Veldhoven (NL); VAN DUIVENBODE, Jeroen, 5500 AH Veldhoven (NL); WULLMS, Pieter, Hubertus, Godefrida, 5500 AH Veldhoven (NL)
(74) Representative: ASML Netherlands B.V.

(57) **Abstract**

An electrical connector comprising a block of non-conductive flexible polymer, an electrical conductor which extends through the non-conductive flexible polymer from a first end to a second end of the non-conductive flexible polymer block, and a conductive flexible polymer sleeve which extends around a side of the non-conductive flexible polymer block.

## Description

### FIELD

The present disclosure relates to an electrical connector for use in a vacuum. The vacuum may be within a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a deep ultraviolet (DUV) wavelength of 193 nm.

The power of EUV radiation which is projected onto a lithographic substrate will determine the speed at which the lithographic substrate can be exposed. A higher power will allow a higher speed of exposure than a lower power, and thus a higher throughput of the lithographic apparatus. EUV radiation is absorbed by air. It is desirable to maintain a vacuum within an EUV lithographic apparatus. This is in order to avoid air attenuating the EUV radiation beam and thereby reducing the power of the EUV radiation beam. In some instances a relative vacuum, i.e. a small amount of gas (e.g. hydrogen) at a pressure well below atmospheric pressure, may be provided in the lithographic apparatus.

Electrical connectors within an EUV lithographic apparatus may be configured to avoid electrical breakdown (which may be referred to as Paschen breakdown). Generation of undesirable contamination particles by an electrical connector within an EUV lithographic apparatus may also be a factor in the configuration of the electrical connector.

It may be desirable to provide an electrical connector that overcomes or mitigates one or more problems associated with the prior art.

### SUMMARY

According to a first aspect of the present disclosure, there is provided an electrical connector comprising a block of non-conductive flexible polymer, an electrical conductor which extends through the non-conductive flexible polymer from a first end to a second end of the non-conductive flexible polymer block, and a conductive flexible polymer sleeve which extends around a side of the non-conductive flexible polymer block.

Advantageously, the electrical connector can provide an electrical connection capable of transmitting high voltages (e.g. 200V or more). Advantageously, a lower clamping force may be applied to the electrical connector compared with some prior art electrical connectors.

The electrical conductor may project beyond the second end of the non-conductive flexible polymer block.

The electrical conductor may comprise a wire.

The electrical conductor may comprise a cylindrical conductor and a resiliently biased pin.

The electrical conductor may be one of a plurality of electrical conductors which extend from the first end to the second end of the non-conductive flexible polymer block.

The conductive flexible polymer sleeve may comprise a polymer provided with conducting particles.

The conductive flexible polymer sleeve may be bonded to the non-conductive flexible polymer block.

The non-conductive flexible polymer block and the conductive flexible polymer sleeve may have been vulcanized together.

The electrical connector may further comprise one or more outwardly projecting conductive flexible polymer portions integrally formed with the conductive flexible polymer sleeve.

The one or more outwardly projecting conductive flexible polymer portions may comprise one or more tabs or one or more flanges.

The electrical conductor may project beyond the first end of the non-conductive flexible polymer block.

The non-conductive flexible polymer may be FKM or FFKM.

The conductive flexible polymer may comprise FKM or FFKM.

According to a second aspect of the invention, there is provided an electrical connector comprising a block of non-conductive flexible polymer, an electrical conductor which extends through the non-conductive flexible polymer block from a first end to a second end of the non-conductive flexible polymer block, a first row of electrical conductors on an outer wall of the non-conductive flexible polymer block, the electrical connectors extending from the first end of the non-conductive flexible polymer block, and a second row of electrical conductors on an outer wall of the non-conductive flexible polymer block, the electrical connectors extending from the second end of the non-conductive flexible polymer block, wherein a gap exists between the first and second rows of electrical conductors.

Advantageously, the electrical connector can provide an electrical connection capable of transmitting high voltages (e.g. 200V or more). Advantageously, a lower clamping force may be applied to the electrical connector compared with some prior art electrical connectors.

According to a third aspect of the invention there is provided an electrical connection assembly comprising the electrical connector according to the first aspect or the second aspect, the electrical connection assembly further comprising a clamp configured to compress the first and second ends of the non-conductive flexible polymer block.

The clamp may comprise first and second clamp faces. The clamp may further comprise an actuator configured to press the first and second clamp faces towards each other.

The actuator may be an electromagnet.

According to a fourth aspect of the invention there is provided an electrical connection formed using the electrical connection assembly according to the third aspect of the invention, wherein the non-conductive flexible polymer block is compressed by a force of up to 100 N, and wherein the electrical conductor connects an electrical circuit located at the first end of the non-conductive flexible polymer block to an electrical circuit located at the second end of the non-conductive flexible polymer block.

According to a fourth aspect of the invention there is provided a method of making an electrical connection using an electrical connector, the electrical connector comprising a block of non-conductive flexible polymer, an electrical conductor which extends through the non-conductive flexible polymer from a first end to a second end of the non-conductive flexible polymer block, and a conductive flexible polymer sleeve which extends around a side of the non-conductive flexible polymer block; wherein the method comprises: bringing a first end of the non-conductive flexible polymer block into contact with a contact surface provided with an electrical contact such that the electrical conductor is in contact with the electrical contact, and applying a clamping force which compresses the non-conductive flexible polymer block such that there is substantially no void between the electrical conductor and the non-conductive flexible polymer block.

Advantageously, the electrical connection that is formed can provide an electrical connection capable of transmitting high voltages (e.g. 200V or more). Advantageously, a lower clamping force may be applied to the electrical connector compared with some prior art electrical connectors.

The clamping force may compress the non-conductive flexible polymer block such that there is substantially no void between the first end of the non-conductive flexible polymer block and the contact surface.

Features of different aspects of the disclosure may be combined together.

### BRIEF DESCRIPTION OF THE DRAWINGS

Embodiments of the disclosure will now be described, by way of example only, with reference to the accompanying schematic drawings, in which:
- Figure 1 schematically depicts a lithographic system which includes an electrical connector according to an embodiment of the disclosure;
- Figure 2 is a perspective view of an electrical connector according to an embodiment of the disclosure;
- Figure 3 is a cross-sectional view of an electrical connection assembly which comprises the electrical connector of Figure 2;
- Figure 4 is a view from below of an electrical connection assembly which comprises electrical connectors according to an embodiment of the disclosure;
- Figure 5 is a cross-sectional side view of part of the electrical connection assembly;
- Figure 6 is a is perspective view of an electrical connector according to another embodiment of the disclosure;
- Figure 7 is a cross-sectional view of an electrical connector according to another embodiment of the disclosure;
- Figure 8 is a cross-sectional view of an electrical connector according to another embodiment of the disclosure; and
- Figure 9 is a cross-sectional view of an electrical connector according to another embodiment of the disclosure.

### DETAILED DESCRIPTION

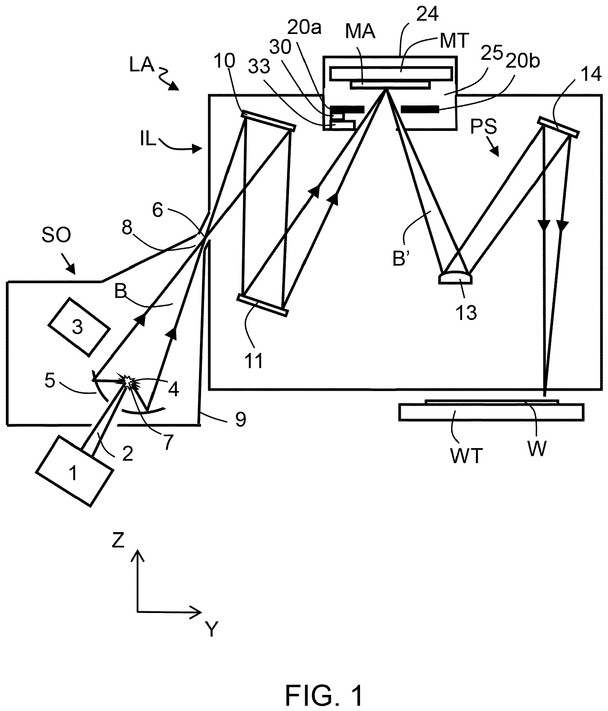

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The patterning device MA and other elements may be provided within a housing 24. An interior defined by the housing may be referred to as a patterning device environment 25. The housing 24 may be substantially closed, apart from an opening at a bottom end of the housing. Masking blades 20a,b are provided in the patterning device environment 25. The masking blades 20a,b are used to selectively mask areas of the patterning device MA, such that only a desired portion of the patterning device receives EUV radiation at any given time.

An electrical connector 30 according to an embodiment of the disclosure connects a left hand masking blade 20a to an electrical power supply 33. Electrical power which delivered from the power supply 33 via the electrical connector 30 is used to move the left hand masking blade 20a (e.g. in a scanning direction of the lithographic apparatus). Another electrical connector (not depicted) may be used to connect the right hand masking blade 20b to a power supply (not depicted). Alternatively, power which passes via the depicted electrical connector 30 may be delivered to the right hand masking blade 20b in addition to the left hand masking blade 20a. The electrical connector 30 is described in detail further below. Although the depicted electrical connector 30 provides a connection between a masking blade and a power supply, the electrical connector may be provided at a different location in the lithographic apparatus. The electrical connector 30 may be provided wherever an electrical connection is needed. The electrical connector 30 may be provided at locations in the lithographic apparatus where a high voltage (e.g. 200 V or more, e.g. up to 5.5 kV or more) is being handled. The electrical connector 30 may be provided at locations in the lithographic apparatus where it is desirable to be able to engage and disengage electrical connection without manual handling (e.g. in a vacuum environment of the lithographic apparatus).

During a scanning exposure, the patterning device MA and support structure MT move in the y-direction, and the substrate W and substrate table WT move in the opposite y-direction (and vice-versa). In this way, a band of EUV radiation passes over the patterning device MA and passes over an exposure field on the substrate W.

A relative vacuum, i.e. a small amount of gas (e.g. hydrogen) at a pressure well below atmospheric pressure, may be provided in the radiation source SO, in the illumination system IL, and/or in the projection system PS. The same is also the case for the patterning device environment 25. That is, gas at a pressure below atmospheric pressure is present in the patterning device environment 25. The gas may for example be hydrogen.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

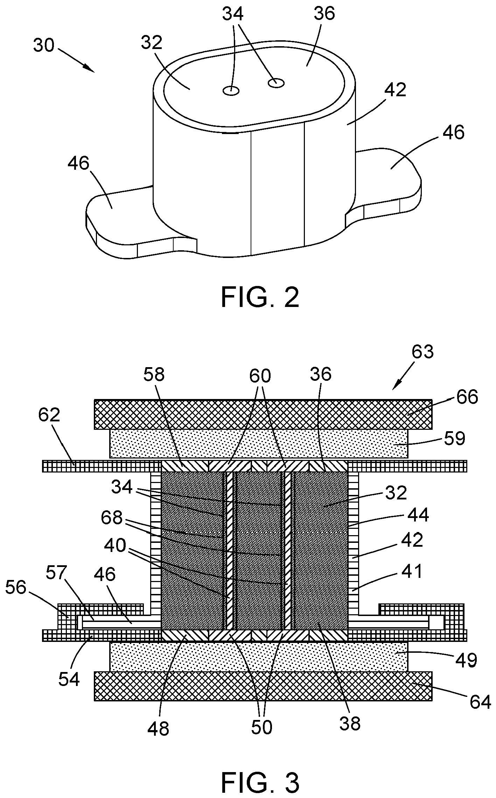

Figure 2 depicts in perspective view an electrical connector 30 according to an embodiment of the disclosure. Figure 3 depicts in cross section an electrical connection assembly which includes the electrical connector 30.

The electrical connector 30 comprises a block of non-conductive flexible polymer 32. The block of non-conductive flexible polymer 32 may be referred to herein as an insulating polymer block or merely as a polymer block 32. Two holes 34 extend from an upper end 36 of the polymer block 32 to a lower end 38 of the polymer block. An electrical conductor 40 (not depicted in Figure 2) extends through each hole 34 and thus extends through the polymer block 32. The electrical conductors 40 are described in detail further below. A void 68 exists between each electrical conductor 40 and an inner wall of the hole 34 through which the electrical conductor extends.

The polymer block 32 has a side-wall 44. A sleeve of conductive flexible polymer 42 extends around a side wall 44 of the polymer block 32. The sleeve of conductive flexible polymer 42 forms a conductive outer wall 41 of the electrical connector 30. A pair of tabs 46 are integrally formed with the conductive flexible polymer wall 41 and extend outwardly from the conductive flexible polymer wall. The depicted pair of tabs 46 is one example of a portion of conductive flexible polymer which projects outwardly from the polymer wall 41. This outwardly projecting conductive flexible polymer portion, which is integrally formed with the polymer wall, may have a different configuration. For example, a single tab may be provided, one or more tabs may be provided e.g. at the top and/or the bottom of the polymer wall. A flange which extends around the polymer wall may be provided, e.g. at the top and/or bottom of the polymer wall. The outwardly projecting conductive flexible polymer portion may allow easy connection of the polymer wall to ground, e.g. by engaging the projection in an opening of the lithographic apparatus that is connected to ground. Other forms of connection to ground may be provided, e.g. a wire which extends from the polymer wall to a grounded part of the lithographic apparatus.

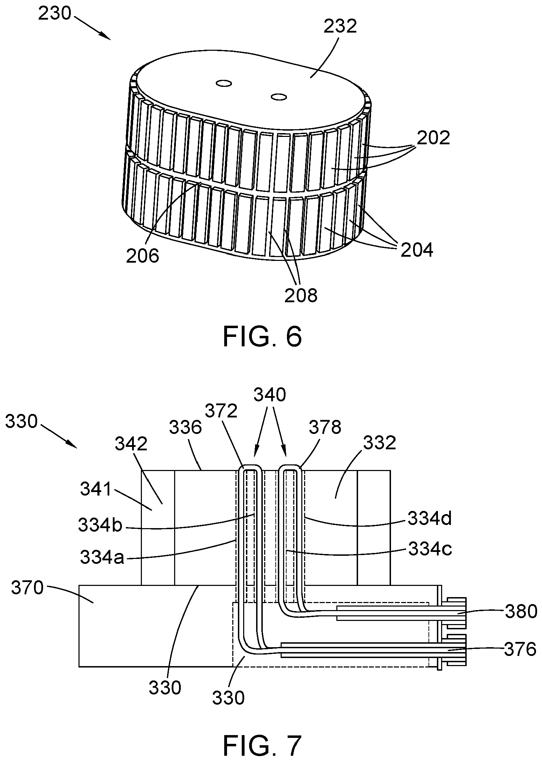

In figure 3, the electrical connection assembly comprises the electrical connector 30 along with other components. A first insulator block 48 is provided at that a lower end 38 of the polymer block 32. The first insulator block 48 includes electrical contacts 50 which are electrically connected to the electrical conductors 40. The first insulator block 48 is an example of a contact surface. The contact surface may have any suitable form for this embodiment and for other embodiments. The form of electrical connection may for example be as described below in connection with figures 7 to 9.

A PCB 49, or other electrical system, is electrically connected to the electrical contacts 50. The PCB 49 has an insulating exterior. In other embodiments, the PCB 49 may include other components that are depicted as being separate from the PCB in Figure 3. For example the PCB may comprise one or more of the first plate 54 (which may be formed from a material other than metal), the first insulator block 48 and the electrical contacts 50. For example, a PCB with an insulating exterior and with electrical contacts 50 may be provided in place of the depicted separate PCB 49, first insulator block 48 and first metal plate 62.

The first insulator block 48 is provided in a recess provided in a first metal plate 54. The metal plate 54 includes projections 56 which define recesses 57 that are configured to receive the tabs 46 of the conducting polymer 42. The projections 56 are conducting and provide an electrical connection to the tabs 46 of conducting polymer 42. The metal plate 54 is connected to ground, and thus the tabs 46 of conductive flexible polymer 42 and the conductive flexible polymer wall 41 are also connected to ground.

A second insulator block 58 is provided at the upper end 36 of the polymer block 32. The second insulator block 58 includes electrical contacts 60 which are electrically connected to the electrical conductors 40 (as described further below). The second insulator block 58 is an example of a contact surface. The contact surface may have any suitable form for this embodiment and for other embodiments. The second insulator block 58 is received in a recess provided in a second metal plate 62. The second metal plate 62 is in electrical contact with the conductive flexible polymer wall 41. In other embodiments, the second metal plate 62 is not in contact with the conductive flexible polymer wall 41. Where this is the case, the second metal plate 62 may be connected to ground via a different connection.

A PCB 59, or other electrical system, is electrically connected to the electrical contacts 60. The PCB 59 has an insulating exterior. In other embodiments, the PCB may include other components that are depicted as being separate from the PCB in Figure 3. For example the PCB may comprise one or more of the second plate 62 (which may be formed from a material other than metal), the second insulator block 58 and the electrical contacts 60. For example, a PCB with an insulating exterior and with electrical contacts 60 may be provided in place of the depicted separate PCB 59, second insulator block 58 and second metal plate 62.

A clamp 63 comprising first and second clamp faces 64, 66 is provided at the top and the bottom of the electrical connector 30. The first clamp end 64 is located below the first PCB 49 and the first metal plate 54. The second clamp end 66 is located above the second PCB 59 and the second metal plate 62. A clamp actuator (not depicted) is used to press the first and second clamp faces 64, 66 towards each other. The clamp actuator may for example comprise an electromagnet. The clamp actuator may alternatively comprise bolts which pass through the first and second clamp faces 64, 66 (and may also pass through the first and second metal plates 54, 62).

When the first and second clamp faces 64, 66 are pressed towards each other, the polymer block 32 is compressed. As a result of this compression, the void 68 which is present between each electrical conductor 40 and a respective hole 34 is substantially eliminated. In addition, any void which may be present between the polymer block 32 and the first insulator block 48 or between the polymer block and the second insulator block 58 is substantially eliminated. Advantageously, substantially eliminating voids in this manner ensures that there is no path via a void from the conductors 40 or the contacts 50, 60 to ground, thereby reducing the risk of an electrical breakdown.

When the polymer block 32 is compressed, the side wall 44 of the polymer block bulges outwardly. The conductive flexible polymer 42 which surrounds the polymer block 32 is flexible. This allows the conductive flexible polymer 42 to also bulge outwards such that the conductive flexible polymer does not prevent compression of the polymer block 32.

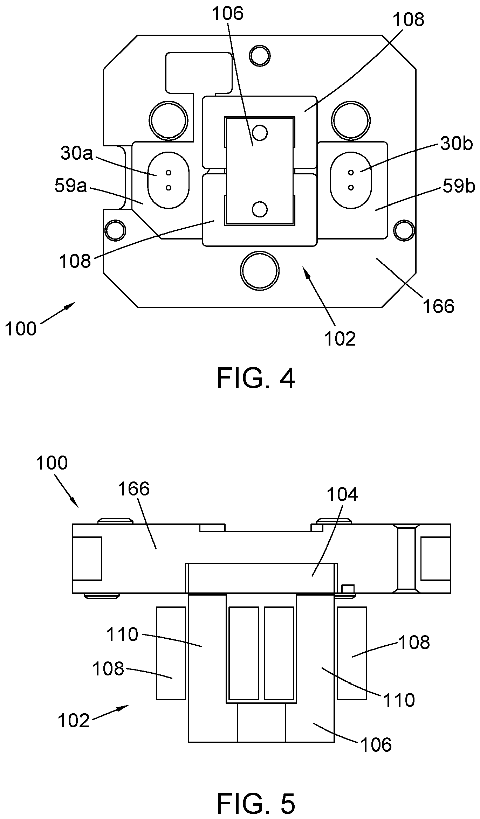

Figure 4 depicts an electrical connection assembly 100 viewed from below Figure 5 depicts in side view cross-section part the electrical connection assembly. As may be seen, the electrical connection assembly 100 comprises two electrical connectors 30 according to an embodiment of the disclosure.

The electrical connection assembly 100 comprises a first electrical connector 30a and a second electrical connector 30b provided on a metal plate 166. The metal plate 166 may correspond with the second clamp face 66 of the embodiment depicted in figures 2 and 3. In other words, the metal plate 166 may act as part of a clamp which compresses the electrical connectors 30 in use. The metal plate 166 may be formed from aluminium. A first PCB 59a extends from and is electrically connected to the first electrical connector 30a. A second PCB 59b extends from and is electrically connected to the second electrical connector 30b. An electromagnet system 102 is located between the first and second electrical connectors. The electrical connection assembly 100 further comprises a second metal plate (not depicted) which supports part of the electromagnet system 102 and also is provided with first and second PCBs. The first and second PCBs are aligned with the first and second electrical connectors 30a,b.

The electromagnet system 102 comprises a first block of ferrous material 104 which is fixed to the metal plate 166. The electromagnet system 102 further comprises a U-shape 106 of ferrous material which is fixed to another metal plate (not depicted). Electrical coils 108 extend around arms 110 of the U-shaped ferrous material 106. Upper ends of the arms 110 of the U-shape material have faces which engage with the block of ferrous material 104 in use.

In use, the metal plates are brought together such that the arms 110 of the U-shaped ferrous material 106 contact the first block of ferrous material 104 (or are adjacent to the first block of ferrous material). An electrical current is passed through the electrical coils 108. The current generates a magnetic field which extends along the arms 110 of ferrous material and attracts the block of ferrous material 104. Thus, the U-shape of ferrous material 106 and the block of ferrous material 104 are drawn together. This drawing together by the electromagnet 102 applies compressive force to the electrical connectors 30a,b. The compressive force may be sufficient to substantially eliminate voids in the electrical connectors 30a,b. The force which is applied may for example be around 10 N or more. The force which is applied may for example be around 60 N or less.

In general, an actuator may apply a force of up to 100 N on the electrical connector 30. In general, an actuator may apply a force of 10 N or more on the electrical connector 30. The force may be sufficient to ensure that there is substantially no void between the electrical conductors and the polymer block of each electrical connector 30, and substantially no void between faces of the electrical connectors and PCBs which press against the electrical connectors. The force may be significantly less than a force that would be required if the electrical connector comprised a metal conducting sleeve. For example, in an electrical connector with a metal conducting sleeve a force of around 600 N may be required. Applying a relatively low force (compared with a prior art electrical connector with a metal sleeve) is advantageous, because this may be more easily achieved by automated means such as an electromagnet (e.g. as depicted in Figures 4 and 5). In some embodiments a force of less than 10N may be applied by the actuator. This may be less preferred, because the polymer block 32 would need to be softer than conventional polymer (e.g. FKM polymer), in order to ensure that substantially no voids are present.

The polymer block 32 and the conductive flexible polymer wall 41 may be bonded together. This may be achieved for example by vulcanizing the polymer block 32 and the conductive flexible polymer 42.

The polymer block 32 may be formed from rubber, for example from nitrile rubber (NBR), which is also known as acrylonitrile butadiene rubber. The polymer block may for example be formed from FKM or FFKM. FKM or FFKM may be preferred over NBR in a vacuum environment because FKM and FFKM generate less outgassing than NBR.

The conductive flexible polymer 42 may be formed from rubber, for example from nitrile rubber (NBR), which is also known as acrylonitrile butadiene rubber. The conductive flexible polymer may for example be formed from FKM or FFKM. As noted above, FKM or FFKM may be preferred over NBR. Conductivity is provided by mixing the conductive flexible polymer 42 with conducting elements. Carbon nanotubes or other conductive elements may be used to provide conductivity. For example, silver particles or other metal particles may be used. In another example, ceramic particles may be used. In general, any suitable conducting particles may be used. The conductive flexible polymer 42 does not need to be a perfect conductor, but merely should provide sufficient conductivity to give a connection to ground.

The electrical conductors 40 may be configured to accommodate a voltage of 200 V or more, e.g. up to 5.5kV or more, and may be configured to accommodate a current of the order of mA. The electrical conductors 40 may for example be wire (e.g. provided with a metal ring at one end or both ends), conductive rods, or spring-loaded pins. The electrical contacts 50, 60 may for example be metal contact pads.

Although two electrical connectors 30 along with an electromagnet 102 are depicted in Figures 4 and 5, other configurations may be used. For example, a single electrical connector may be provided along with an electromagnet, or some other number of electrical connectors may be provided. The electromagnet is an example of a form of actuator which may be used to provide clamping force. Other forms of actuator may be used, for example bolts which are tightened in order to provide clamping force.

The polymer block 32 may for example have a Shore of less than 80. The polymer block 32 may for example have a Shore which is greater than 40. The polymer block 32 may for example have a Shore in the range 60-70. The Shore of the polymer block 32 may be as low as 30. However, in general, polymers with a Shore as low as 30 tend to give rise to significant outgassing due to fillers that are used to achieve this low Shore. Outgassing is not desirable in a vacuum environment, and is particularly undesirable in an EUV lithography environment (since it gives rise to contamination which may compromise the performance of the lithographic apparatus). For this reason, a Shore of at least 40 may be preferred.

The above shore values may also apply for the conductive flexible polymer 42.

In general, the polymer block 32 may have sufficient flexibility to deform such that there is substantially no void between the electrical conductors 40 and the polymer block 32 when the electrical connector 30 is compressed by an actuator. In general, the polymer block 32 may have sufficient flexibility to deform such that there is no void between the electrical contacts 50, 60 and ground.

The conductive flexible polymer 42 may comprise carbon nanotubes mixed into the polymer. The concentration of the carbon nanotubes may be sufficient to provide the conductive flexible polymer 42 with a desired level of conductivity. The desired conductivity may for example be around 2×10⁶ Ω/m. The desired conductivity may depend at least in part upon a voltage ramp-up speed experienced by the electrical conductors 40 in use.

Other conductive elements may be used instead of carbon nanotubes to provide conductivity to the conductive flexible polymer 42. For example, silver particles or other metal particles may be used. In another example, ceramic particles may be used. In general, any suitable conducting particles may be used. The conductive flexible polymer 42 does not need to be a perfect conductor, but merely should provide sufficient conductivity to give a connection to ground.

The electrical connector 30 may be assembled by forming the polymer block 32 and the conductive flexible polymer 42 as separate elements, and then stretching the conductive flexible polymer around the polymer block. The electrical connector 30 may be heated in order to fuse the polymer block 32 and conductive flexible polymer 42 together. The electrical connector 30 may be vulcanized in order to fuse the polymer block 32 and conductive flexible polymer 42 together. Alternatively, the polymer block 32 and conductive flexible polymer 42 may be glued together. In a further alternative approach, the polymer block 32 and the conductive flexible polymer 42 may be formed together in the same mold. In a further alternative approach the conductive flexible polymer 42 may be stretched around the polymer block 32, the stretching being sufficient to hold the conductive flexible polymer 42 in place.

An electrical connector 230 according to an alternative embodiment of the invention is depicted in Figure 6. In this embodiment a series of metal strips are provided on a block of non-conductive flexible polymer 232. The polymer block 232 may have properties which correspond with the polymer block of other embodiments. Two rows of metal strips are provided. A first row 202 of metal strips is provided above a second row 204 of metal strips. A gap 206 is provided between the first row of metal strips 202 and the second row of metal strips 204. Gaps 208 are also provided between adjacent metal strips of each row 202, 204. Advantageously, this provides improved flexibility (compared with if continuous metal strips were provided), thus allowing easy compression of the electrical connector. In use, when the electrical connector 230 is compressed (e.g. by a clamp) the compression moves the first and second rows 202, 204 towards each. The metal strips of the rows 202, 204 may contact each other. The metal strips 200 thus form combined metal strips which are capable of conducting electricity from an upper end of the electrical connector 30 to a lower end of the electrical connector. Thus, the combined metal strips 210 provide the same conductive functionality as the conductive flexible polymer 42 of other embodiments. In an embodiment, the first row of metal strips 202 is connected to ground and the second row of metal strips 204 is separately connected to ground. Where this is the case, the metal strips of the rows 202, 204 provide connection to ground irrespective of whether the rows of metal strips contact each other.

Figure 7 schematically depicts in cross section an electrical connector 330 according to an embodiment of the disclosure. The electrical connector 330 comprises a block of non-conductive flexible polymer 332 and a sleeve 341 of conductive flexible polymer 342. One or more tabs, or other projections, may be integrally formed with the conductive flexible polymer 342.

A block of insulator 370 is located beneath the electrical connector 330. The block of insulator 370 may be fixed to the polymer block 332 and the conductive flexible polymer sleeves 342.

A first conductor 340 comprises a first wire 372. The first wire 372 extends from a lower end 338 of the block of insulator 370 through a first hole 334a across part of an upper end 336, and through a second hole 334b to the lower face. The first wire 372 thus forms a loop which passes from beneath the lower end 338 of the polymer block 332 to the upper end 336 and back again. The first wire 372 passes into an opening 374 in the block of insulator 370. The wire may is connected to an electrical contact, for example a pin 376 which extends out of the block of insulator 370. The block of insulator may for example be formed from PEEK.

A second conductor 340 comprises a second wire 378. The second wire 378 similarly extends from the lower end 338 of the polymer block 332, through a hole 334c across part of the upper end 336 and back through another hole 334d. The second wire 378 is also received in the opening 374 in the block of insulator 370. The second wire 378 may also be connected to an electrical contact, for example a pin 380 which extends out of the block of insulator 370

In use, the electrical connector 330 is connected to a PCB or other electrical system. When it is desired to connect the PCB to another PCB, the electrical connector 330 is moved such that the wires 372, 378 at the upper end 336 come into contact with electrical contacts of another PCB (e.g. as depicted in Figure 3). Compressive force is then applied which compresses the non-conductive flexible polymer block 332. The compression of the non-conductive flexible polymer block 332 closes any voids in the hole 334a-d through which the wires 372, 378 pass, thereby reducing a risk of electrical discharge. The compressive force may be provided by an actuator which applies force via a clamp depicted in Figure 7.

The embodiment depicted in Figure 7 differs from the embodiment depicted in Figure 3 in that it has wires which extend out of the lower end 338, whereas in Figure 3 contacts are provided at the lower end 38. In general, the electrical connector may include a configuration of electrical conductor which is arranged to press against contacts when the electrical connector is used. These may be provided at both faces of the polymer block, as depicted in Figure 3, or may be provided on one end of the polymer block, as depicted in Figure 7.

The opening 374 in the block of insulator 370 may be filled with electrically insulating material. The electrically insulating material may be referred to as potting material.

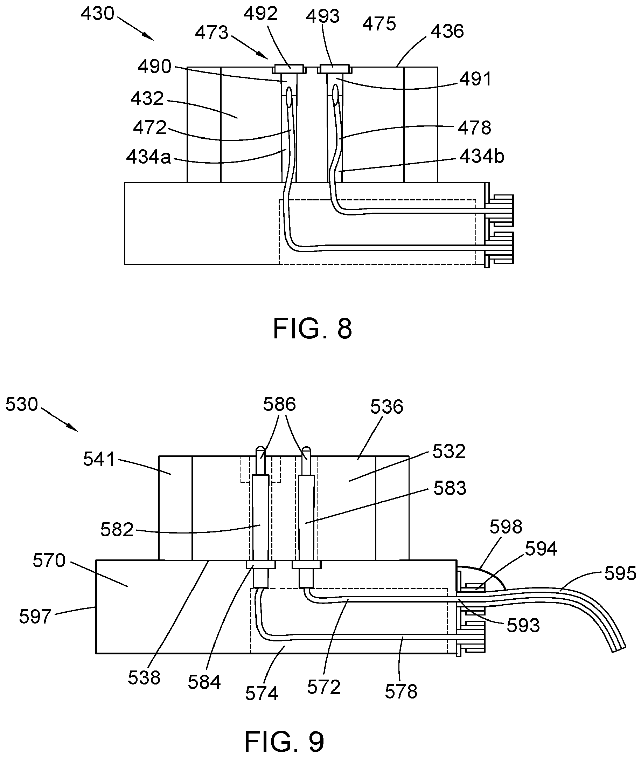

Figure 8 depicts an electrical connector 430 according to another embodiment of the disclosure. This electrical connector 430 generally corresponds with the electrical connector depicted in Figure 7, and features of the electrical connector described above in connection with Figure 7 are not described again in connection with Figure 8. In Figure 8 a first wire 472 is not arranged as a loop but instead is connected to a first electrical contact 473 which is located at the upper end 436 of the non-conductive flexible polymer block 432. The first wire 472 may be connected to the first contact 473 via any suitable connection, e.g. solder, passing through an opening provided in the contact, etc. The first contact 473 may include a downwardly projecting part 490 which is received in a hole 434a through which the first wire 472 passes. The hole 434a and the downwardly projecting part 490 of the first contact 473 may be generally cylindrical. The electrical contact 473 includes a contact end 492 which projects above the upper end 436 of the non-conductive flexible polymer block.

A second wire 478 is connected to a second electrical contact 475 which is located at the upper end 436 of the non-conductive flexible polymer block 432. The second wire 478 may be connected to the second contact 475 via any suitable connection, e.g. solder, passing through an opening provided in the contact, etc. The second contact 475 may include a downwardly projecting part 491 which is received in a hole 434b through which the second wire 478 passes. The hole 434b and the downwardly projecting part 491 of the second contact 475 may be generally cylindrical. The second electrical contact 475 includes a contact end 493 which projects above the upper end 436 of the non-conductive flexible polymer block.

Use of the electrical connector 430 may be as described above in connection with the electrical connector of Figure 7.

Figure 9 schematically in cross section an electrical connector 530 according to a further alternative embodiment of the disclosure. The electrical connector 530 generally corresponds with those depicted in Figures 7 and 8, and features in common with those embodiments are not described again.

Instead of a wire, a first cylindrical conductor 582 extends from the lower end 538 to the upper end 536 of the non-conductive flexible polymer block 532. The first cylindrical conductor 582 also extends into the block of insulator 570. A flange 584 extends around the first cylindrical conductor 582 at the lower end 538 of the polymer block 532. The flange 584 may be received in a recess formed in the block of insulator 570. The flange 584 may assist in ensuring that the first cylindrical conductor 582 is correctly positioned with respect to the block of insulator 370 and the polymer block 532. A resiliently biased pin 586 extends from an upper end of the first cylindrical conductor 582. The pin 586 is biased upwards such that when there is nothing located above the upper end 536 of the polymer block 532 the pin projects beyond the upper surface.

A second cylindrical conductor 583 extends from the lower end 538 to the upper end 536 of the non-conductive flexible polymer block 532. Features of the second cylindrical conductor 583 correspond with the first cylindrical conductor and for brevity are not described.

A first wire 572 is electrically connected to the first cylindrical conductor 582. The first wire 572 passes through an opening 574 in the block of insulator 570 and out of a hole 593 in the block of insulator. The first wire 572 is connected to a coaxial connector 594 which is fixed to the exterior of the block of insulator 570. The coaxial connector 594 is connected to a coaxial cable 595. The first wire 572 is connected to an inner wire of the coaxial cable 595. A conductive outer sheath 596 of the coaxial cable 595 is secured to a conducting outer portion of the coaxial connector 594. The conductive outer sheath 596 is connected to ground. A corresponding arrangement (only partially depicted) may be provided for a second wire 578. Connection to coaxial cable may be similarly provided for other embodiments.

In use, a PCB having electrical contacts is located above the resiliently biased pins 586. This pushes the resiliently biased pins 586 downwards. Compressive force is applied which causes compression of the polymer block 532. This further pushes the resiliently biased pins 586 downwards. This movement of the resiliently biased pins accommodates the compression provided by the compressive force, such that the cylindrical conductors 582 are not bent or otherwise damaged by the compressive force.

A conductive layer 597 is provided on an outer surface of the block of insulator 570. The conductive layer is connected by a wire 598 to the conductive outer sheath 596 of the coaxial cable 595. This provides a connection to ground. A conductive outer portion of the coaxial connector 594 is in contact with the conductive layer 597. This also provides a connection to ground. In general, a connection between the conductive outer layer 597 and the conductive outer sheath 596 of the coaxial cable 595 may be provided.

A sleeve 541 of conductive flexible polymer is in contact with the conductive layer 597. This provides a connection to ground for the sleeve 541. The conductive layer 597 does not extend to the polymer block 532 and is not in contact with the polymer block. Similarly, the conductive layer 597 does not extend to the first and second wires 572, 578 and is not in contact with the first and second wires.

A generally corresponding conductive layer may be provided for other embodiments. A generally corresponding connection to ground, e.g. via coaxial cable, may be provided for other embodiments.

In the embodiments of Figures 7 and 8 the wires 372, 378, 472, 478 are able to bend to accommodate the compression of the polymer block.

Other forms of electrical conductor may be used.

The electrical conductors may project above an upper end of the non-conductive flexible polymer block.

In embodiments of the disclosure, the non-conductive flexible polymer block is described as having an upper end and a lower end. This is for ease of description and is not intended to mean that the electrical connector must have a particular orientation. The electrical connector may have any orientation. The upper end of the polymer block may be more generally referred to as a first end of the polymer block, and the lower end of the polymer block may be more generally referred to as a second end of the polymer block.

A method according to an embodiment of the disclosure may be performed by a computing device. The device may comprise a central processing unit ("CPU") to which is connected a memory. The method described herein may be implemented in code (software) stored on a memory comprising one or more storage media, and arranged for execution on a processor comprising one or more processing units. The storage media may be integrated into and/or separate from the CPU. The code, which may be referred to as instructions, is configured to be fetched from the memory and executed on the processor to perform operations in line with embodiments discussed herein. Alternatively it is not excluded that some or all of the functionality of the CPU is implemented in dedicated hardware circuitry, or configurable hardware circuitry like an FPGA.

The computing device may comprise an input configured to enable a user to input data into a software program running on the CPU. The input device may comprise a mouse, keyboard, touchscreen, microphone etc. The computing device may further comprise an output device configured to output results of measurements to a user.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the disclosure in the context of a lithographic apparatus, embodiments of the disclosure may be used in other apparatus. Embodiments of the disclosure may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the disclosure in the context of optical lithography, it will be appreciated that the disclosure, where the context allows, is not limited to optical lithography and may be used in other applications, for example imprint lithography.

Where the context allows, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the disclosure have been described above, it will be appreciated that the disclosure may be practiced otherwise than as described. The descriptions above are intended to be illustrative, not limiting. Thus it will be apparent to one skilled in the art that modifications may be made to the disclosure as described without departing from the scope of the claims set out below.

### Clauses

1. A method of making an electrical connection using an electrical connector, the electrical connector comprising a block of non-conductive flexible polymer, an electrical conductor which extends through the non-conductive flexible polymer from a first end to a second end of the non-conductive flexible polymer block, and a conductive flexible polymer sleeve which extends around a side of the non-conductive flexible polymer block; wherein the method comprises:
   bringing a first end of the non-conductive flexible polymer block into contact with a contact surface provided with an electrical contact such that the electrical conductor is in contact with the electrical contact, and applying a clamping force which compresses the non-conductive flexible polymer block such that there is substantially no void between the electrical conductor and the non-conductive flexible polymer block.
2. The method of clause 1, wherein the clamping force compresses the non-conductive flexible polymer block such that there is substantially no void between the first end of the non-conductive flexible polymer block and the contact surface.

## Claims

1. An electrical connector comprising a block of non-conductive flexible polymer, an electrical conductor which extends through the non-conductive flexible polymer from a first end to a second end of the non-conductive flexible polymer block, and a conductive flexible polymer sleeve which extends around a side of the non-conductive flexible polymer block.

2. The electrical connector of claim 1, wherein the electrical conductor projects beyond the second end of the non-conductive flexible polymer block or/and
wherein the electrical conductor comprises a wire.

3. The electrical connector of claim 1 or claim 2, wherein the electrical conductor comprises a cylindrical conductor and a resiliently biased pin.

4. The electrical connector of any preceding claim, wherein the electrical conductor is one of a plurality of electrical conductors which extend from the first end to the second end of the non-conductive flexible polymer block.

5. The electrical connector of any preceding claim, wherein the conductive flexible polymer sleeve comprises a polymer provided with conducting particles or/and
wherein the conductive flexible polymer sleeve is bonded to the non-conductive flexible polymer block.

6. The electrical connector of any preceding claim, wherein the non-conductive flexible polymer block and the conductive flexible polymer sleeve have been vulcanized together.

7. The electrical connector of any preceding claim, further comprising one or more outwardly projecting conductive flexible polymer portions integrally formed with the conductive flexible polymer sleeve.

8. The electrical connector of claim 7, wherein the one or more outwardly projecting conductive flexible polymer portions comprise one or more tabs or one or more flanges.

9. The electrical connector of any preceding claim, wherein the electrical conductor projects beyond the first end of the non-conductive flexible polymer block or/and
wherein the non-conductive flexible polymer is FKM or FFKM.

10. The electrical connector of any preceding claim, wherein the conductive flexible polymer comprises FKM or FFKM.

11. An electrical connector comprising:
a block of non-conductive flexible polymer;
an electrical conductor which extends through the non-conductive flexible polymer block from a first end to a second end of the non-conductive flexible polymer block;
a first row of electrical conductors on an outer wall of the non-conductive flexible polymer block, the electrical connectors extending from the first end of the non-conductive flexible polymer block; and
a second row of electrical conductors on an outer wall of the non-conductive flexible polymer block, the electrical connectors extending from the second end of the non-conductive flexible polymer block;
wherein a gap exists between the first and second rows of electrical conductors.

12. An electrical connection assembly comprising the electrical connector of any preceding claim, and further comprising a clamp configured to compress the first and second ends of the non-conductive flexible polymer block.

13. The electrical connection assembly of claim 12, wherein the clamp comprises first and second clamp faces, and further comprises an actuator configured to press the first and second clamp faces towards each other.

14. The electrical connection assembly of claim 13, wherein the actuator is an electromagnet.

15. An electrical connection formed using the electrical connection assembly of any of claims 11 to 14, wherein the non-conductive flexible polymer block is compressed by a force of up to 100 N, and wherein the electrical conductor connects an electrical circuit located at the first end of the non-conductive flexible polymer block to an electrical circuit located at the second end of the non-conductive flexible polymer block.
